# EUROPÄISCHE PATENTSCHRIFT

(11) **EP 2 436 244 B1**
(45) Veröffentlichungstag und Bekanntmachung des Hinweises auf die Patenterteilung: **18.12.2013**
(21) Anmeldenummer: 10739468.6
(22) Anmeldetag: 26.05.2010
(51) Int. Cl.: H05K 5/02, G06K 19/077

(54) **ELEKTRONISCHES SPEICHERMEDIUM**
ELECTRONIC STORAGE MEDIUM
SUPPORT D'ENREGISTREMENT ÉLECTRONIQUE

(30) Priorität: 16.02.2010 DE 102010008632; 27.05.2009 DE 102009022787; 15.09.2009 DE 102009041108
(43) Veröffentlichungstag der Anmeldung: 04.04.2012
(73) Patentinhaber: Emami, Arman, 10435 Berlin (DE)
(72) Erfinder: Emami, Arman, 10435 Berlin (DE)
(74) Vertreter: Kietzmann, Manfred
(86) Internationale Anmeldenummer: PCT/DE2010/000590
(87) Internationale Veröffentlichungsnummer: WO 2010/136025

(56) Entgegenhaltungen:
- EP-A2- 1 755 072
- CN-Y- 201 178 536
- GB-A- 584 761
- GB-A- 2 444 650
- US-A1- 2003 101 545
- US-A1- 2006 118 639

## Beschreibung

Die Erfindung betrifft einen USB-Stick, der sich an Unterlagen wie Briefpapier oder Visitenkarten in ähnlicher Weise wie eine Büroklammer befestigen lässt.

Durch die technische Entwicklung werden die elektronischen Speichermedien, insbesondere USB-Sticks, in der Produktion und Anschaffung ständig kleiner und günstiger. Dieser Effekt führt dazu, dass solche Datenträger immer mehr Einsatz bei der Archivierung und Weitergabe der Informationen an den Dritten finden. Durch Volumenreduzierung solcher Datenträger entsteht allerdings gleichzeitig die Gefahr, dass diese beim Transport bei der Weitergabe oder Archivierung nicht leicht auffindbar sind bzw. nicht sofort wahrgenommen werden oder sogar verloren gehen.

Dazu wird in der GB 2 444 650 A vorgeschlagen, einen USB-Stick einer Büroklammer nachzuempfinden, so dass er an einem Trägermaterial befestigt werden kann.

Aus der CN 2011 78 536 Y ist es weiter bekannt, an einem USB-Stick eine federnde Klemmlasche anzuordnen, um den USB-Stick so auf einem Trägermaterial zu fixieren.

Aus der US 2006/0118639 A1 und der EP 1 755 072 A2 sind weiter Karten bekannt, in denen Speichermedien in einem aus der Kartenebene herausbiegbaren Abschnitt angeordnet sind.

Die US 2003/0101545 A1 beschreibt eine Büroklammer mit in einer Ebene liegenden Klemmteilen, wobei durch ein Aufklaffen eine Spannwirkung auf die dazwischen angeordneten Papierseiten ausübbar ist.

Aufgabe der Erfindung ist es, einen USB-Stick vorzuschlagen, der sich sicher durch Klemmen auf einer Unterlage befestigen lässt und diese möglichst wenig verformt.

Gelöst wird diese Aufgabe durch die Merkmale des Anspruches oder des Ansprunches 2. 1. Vorteilhafte Ausgestaltungen sind Gegenstand der Unteransprüche.

Die erfindungsgemäße USB-Stick lässt sich lediglich durch seine Form an Unterlagen befestigen ohne die gewünschte und meistens für den Transport notwendige Flachheit des Datenträgers durch zusätzliche Konstruktionen und Befestigungsvorrichtungen zu stören. Somit bleiben die USB-Sticks möglichst flach und fast zweidimensional und können trotzdem wie eine flache Büroklammer leicht und bequem an den Unterlagen befestigt werden.

Als strukturierte Oberfläche haben sich Rauhigkeiten, Riffelungen und/oder punktuelle und/oder linienförmige Erhebungen und/oder eingebrachte Absenkungen bewährt. Eine weitere oder ergänzende Ausführung der strukturierten Oberfläche wird in wellenförmigen Teilflächen, in wellenförmigen Drahtschenkeln des Drahtes oder in wellenförmigen Plättchen gesehen.

Diese strukturierten Oberflächen können sowohl bei der Herstellung der Stickfläche, der parallel abgesenkten Teilflächen oder der Drahtschenkel oder der Plättchen auf- oder eingebracht werden als auch bei einem nachträglichen Bearbeiten.

Bei einer anderen Ausführung besitzt die strukturierte Oberfläche klebende Eigenschaften. Dies ist durch Klebestreifen mit einer abziehbaren Schutzfolie realisiert werden.

Das Maß der Absenkung ist dabei gleich als die Höhe der Stickfläche sein, wenn die Flächigkeit des Speichermediums von besonderer Bedeutung ist.

Die Erhebungen der strukturierten Oberfläche der abgesenkten Fläche können in die durch das Absenken entstehende Öffnung in der Stickfläche hineinragen.

Wesentlich für einen guten Halt des Sticks auf dem Trägermateriel ist, dass zwischen, dem Draht oder dem Plättchen und der restlichen Oberfläche des Sticks eine Vorspannung besteht.

Deshalb werden der Draht oder das Plättchen unter Vorspannung am Stick befestigt.

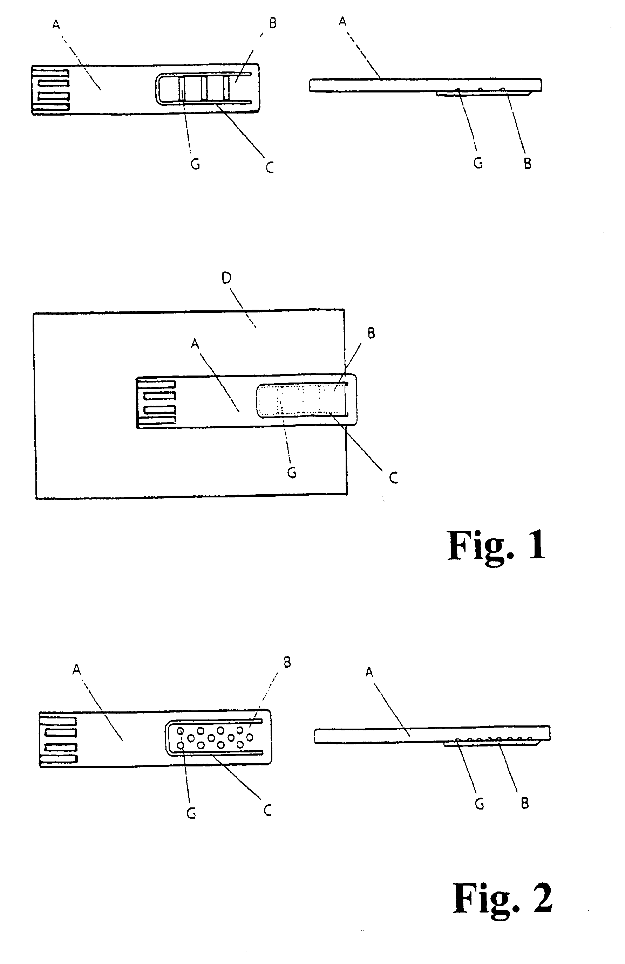

Die Erfindung soll an einigen Ausführungsbeispielen erläutert werden:
Es zeigen: Fig. 1: USB-Stick mit abgesenkter Fläche und strukturierter Innenfläche, Fig. 2: USB-Stick mit abgesenkter Fläche und Riffelungen,
- Fig. 1:: USB-Stick mit abgesenkter Fläche und strukturierter Innenfläche,
- Fig. 2:: USB-Stick mit abgesenkter Fläche und Riffelungen,
- Fig. 3:: USB-Stick mit Drahtbügel
- Fig. 4:: USB-Stick mit Plättchen und
- Fig. 5:: mit wellenförmigem Plättchen.

Bei der Darstellung in **Fig. 1** ist die Fläche (B) gegenüber der Ebene der Fläche (A) etwas abgesenkt und weist gleichzeitig auf der Innenseite eine strukturierte Oberfläche (G) in Form von linienförmigen Erhebungen auf. Diese drücken linienförmig auf das Trägermaterial (D). Die aus der Elastizität resultierende Rückstellkraft wirkt nicht flächig auf das Trägermaterial (D) sondern nur im Bereich der linienförmigen Erhebungen, hier aber mit einer größeren Kraft, was u.a. dazu beiträgt, die Abrutschgefahr zu minimieren.

Dabei können die Erhebungen der strukturierten Oberfläche (G) der abgesenkten Fläche (B) in die durch das Absenken entstehende Öffnung in der Fläche (A) hineinragen.

**Fig. 2** zeigt eine ähnliche Ausführung. Die zur Erziehung der Klemmwirkung aus der Fläche (A) herausdrückbare Fläche (B) ist gegenüber der Fläche (A) abgesenkt ausgebildet. Die abgesenkte Fläche (B) verläuft dabei parallel zur Ebene der Fläche (A). Das Maß der Absenkung ist hier gleich der Höhe der Fläche (A), um die flache Form des USB-Sticks beizubehalten. Als strukturierte Oberfläche (G) weist die Fläche (B) aufgebrachte oder eingebrachte Rauhigkeiten auf. Diese können durch Einprägen in die Oberfläche hergestellt sein oder auch durch das Aufbringen einer entsprechenden Schicht oder von Schichtabschnitten oder von Schichtstufen oder direkt beim Spritzgiessen.

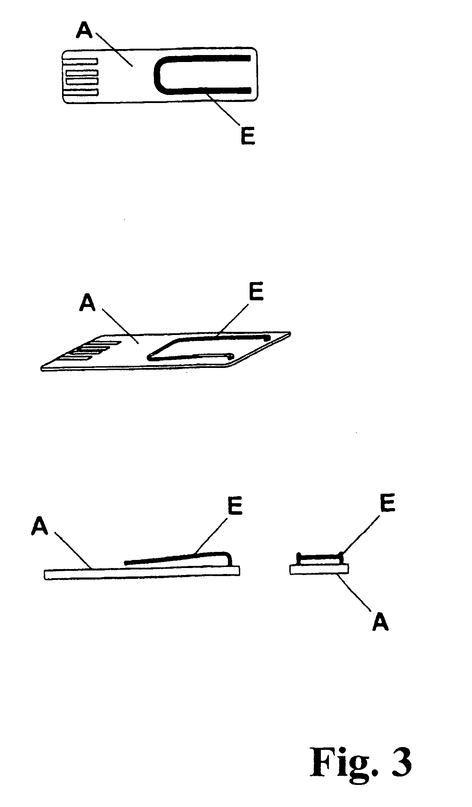

Die **Fig. 3** zeigt eine Ausführungsform, die einen im Wesentlichen U- oder V-förmig verlaufenden Drahtbügel (E) aufweist, der mit seinen beiden freien
Enden an der Gesamtfläche (A) befestigt ist, im Wesentlichen parallel zu dieser liegt. Die Befestigung kann z. B. durch Einstecken der beiden umgebogenen Enden des Drahtbügels (E) in entsprechende Löcher in der Gesamtfläche (A) erfolgen. Das Trägermaterial kann dabei zwischen den Bügel (E) und die Gesamtfläche (A) geklemmt werden.

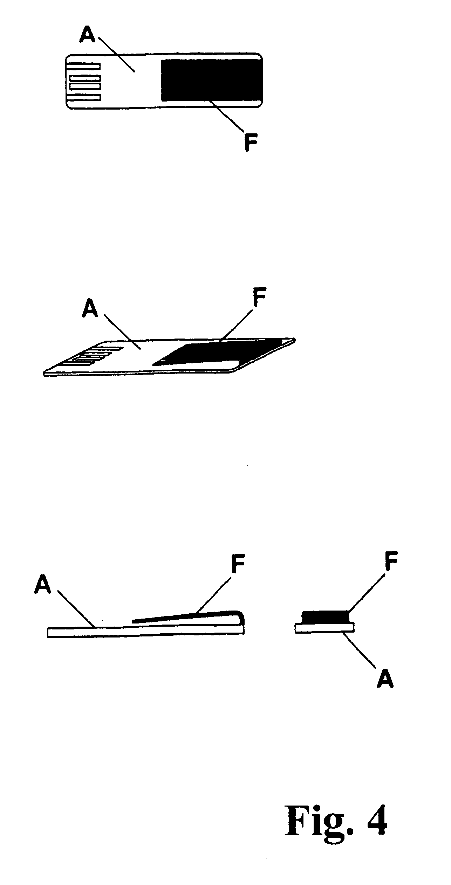

Bei der Ausführungsform gemäß der **Fig. 4** ist anstelle des Bügels bei der Ausführungsform mit einem Draht ein im Wesentlichen rechteckiges Plättchen (F) aus Metall oder Kunststoff vorgesehen, das an einer Kante abgewinkelt und mit dieser Kante an der Gesamtfläche (A) befestigt ist. Dies kann z. B. durch Einstecken in eine entsprechende Nut in der Gesamtfläche (A) oder durch Aufkleben oder Angießen erfolgen. Das Plättchen liegt dabei im Wesentlichen parallel zur Fläche A und nähert sich vorzugsweise mit seinem freien Ende der Fläche A an. Auch bei dieser Ausführungsform wird das Trägermaterial zwischen die Gesamtfläche (A) und das Plättchen (E) geklemmt.

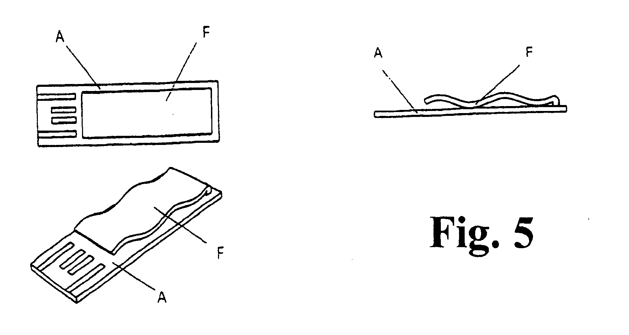

**Fig. 5** zeigt eine Ausführung, bei der ein Plättchen (F) zur Herstellung der Klemmverbindung genutzt wird. Dieses ist wellenförmig ausgeführt, um die Haftung des USB-Sticks auf dem Trägermaterial (D) zu verbessern, wobei das

Plättchen (F) auf der zum Trägermaterial (D) hin weisenden Fläche mit einer strukturierten Oberfläche (G) ausgerüstet ist z.B. in Form von aufgebrachten oder eingebrachten Rauhigkeiten, Riffelungen und/oder punktuellen und/oder linienförmigen Erhebungen, letztere vorzugweise parallel zur Befestigungskante des Plättchens (F) verlaufend.

Die Konstruktion verzichtet bewusst auf komplizierte Befestigungsvorrichtungen sowie zusätzliche Bestandteile und lässt somit eine ökonomische Produktion zu.

## Patentansprüche

1. USB-Stick zum Fixieren auf einem flächigen Trägermaterial (D) aufweisend eine Gesamtfläche (A) aus elastischem Material und eine durch einen Durchbruch aus der Gesamtfläche (A) abgegrenzten Teilfläche (B), die aufgrund der Elastizität des Materials gegenüber der Gesamtfläche (A) aufklaffbar ist, so dass das Trägermaterial zwischen die Gesamtfläche und die Teilfläche klemmbar ist, **dadurch gekennzeichnet, dass**
die Teilfläche (B) gegenüber der Gesamtfläche (A) parallel um ein Maß abgesent ist, das gleich der Höhe der Gesamtfläche (A) ist, und die Teilfläche (B) auf der dem Trägermaterial (D) zugewandten Seite eine strukturierte Oberfläche (G) aufweist.

2. USB-Stick zum Fixieren auf einem flächigen Trägermaterial (D) aufweisend einen im wesentlichen U- oder V-förmig verlaufenden Draht oder ein Plättchen, dessen freie Drahtenden oder dessen eine Plättchenkante an einem flächigen Abschnitt des USB-Sticks befestigt ist und der Draht oder das Plättchen im Wesentlichen parallel zu einem flächigen Abschnitt des USB-Sticks verlaufen, so dass das Trägermaterial zwischen den Draht oder das Plättchen und den flächigen Abschnitt geklemmt werden kann, **dadurch gekennzeichnet, dass** der Draht (E) und das Plättchen (F) auf der dem Trägermaterial (D) zugewandten Seite eine strukturierte Oberfläche (G) mit klebenden Eigenschaften indem ein Klebestreifen mit einer abziehbaren Schutzfolie angeordnet ist aufweist.

3. USB-Stick nach Anspruch 1 oder 2, **dadurch gekennzeichnet, dass**
die strukturierte Oberfläche (G) gebildet ist aus Rauhigkeiten, Riffelungen und/oder punktuellen und/oder linienförmigen Erhebungen und/oder eingebrachten Absenkungen.

4. USB-Stick nach Anspruch 1, **dadurch gekennzeichnet, dass**
die strukturierte Oberfläche (G) über klebende Eigenschaften verfügt.

5. USB-Stick nach Anspruch 1, **dadurch gekennzeichnet, dass**
Erhebungen der strukturierten Oberfläche (G) der abgesenkten Fläche (B) in die durch das Absenken entstehende Öffnung in der Fläche (A) hineinragen.

6. USB-Stick nach einem der Ansprüche 2, **dadurch gekennzeichnet, dass**
das Plättchen (F) wellenförmig ausgebildet ist.

## Claims

1. A USB stick for affixing to a flat carrier material (D), comprising
a total surface area (A) made of elastic material and a partial surface area (B) which is separated from the total surface area (A) by an aperture and can be opened up in relation to the total surface area (A) due to the elasticity of the material, so that the carrier material can be clamped between the total surface area and the partial surface area, **characterized in that**
the partial surface area (B) is lowered in relation to the total surface area (A) in parallel and by a value which is equal to the height of the total surface area (A), and the partial surface area (B) comprises a structured surface (G) on the side facing towards the carrier material (D).

2. A USB stick for affixing to a flat carrier material (D) comprising
a wire running essentially in a U or V form or a disc, the free wire ends of which or one disc edge of which is/are attached to a flat section of the USB stick, wherein the wire or disc runs essentially parallel to a flat section of the USB stick, so that the carrier material can be clamped between the wire or disc and the flat section, **characterized in that**
the wire (E) and the disc (F) on the side facing towards the carrier material (D) have a structured surface (G) with adhesive properties, which are achieved by arranging an adhesive strip with a detachable protective film.

3. The USB stick according to either of claims 1 or 2,
**characterized in that**
the structured surface (G) is formed from unevenness, corrugations and/or punctiform and/or linear elevations and/or inserted depressions.

4. The USB stick according to claim 1, **characterized in that**
the structured surface (G) has adhesive properties.

5. The USB stick according to claim 1, **characterized in that**
elevations in the structured surface (G) of the lowered surface area (B) extend into the opening in the surface area (A) created by lowering said surface area (B).

6. The USB stick according to claim 2, **characterized in that**
the disc (F) is undulated.

## Revendications

1. Clé USB destinée à être fixée sur un matériau support (D) plan, présentant une surface totale (A) en matériau élastique et une surface partielle (B) qui est délimitée par une traversée à partir de la surface totale (A) et qui, du fait de l'élasticité du matériau, peut s'ouvrir par rapport à la surface totale (A) de telle sorte que le matériau support peut être serré entre la surface totale et la surface partielle, **caractérisée en ce que**,
par rapport à la surface totale (A), la surface partielle (B) est abaissée parallèlement sur une distance qui est égale à la hauteur de la surface totale (A), et **en ce que** la surface partielle (B) présente, sur le côté tourné vers le matériau support (D), une surface structurée (G).

2. Clé USB destinée à être fixée sur un matériau support (D) plan, présentant un fil métallique essentiellement en U ou en V ou une plaquette dont les extrémités libres de fil métallique ou dont une arête de plaquette est/sont fixée(s) sur un tronçon plan de la clé USB, et en ce que le fil métallique ou la plaquette est essentiellement parallèle à un tronçon plan de la clé USB de telle sorte que le matériau support peut être serré entre le fil métallique ou la plaquette et le tronçon plan, **caractérisée en ce que**
le fil métallique (E) et la plaquette (F) présentent sur le côté tourné vers le matériau support (D) un surface structurée (G) avec des propriétés adhésives par le fait qu'il est disposé une bande adhésive avec une feuille de protection détachable.

3. Clé USB selon la revendication 1 ou 2, **caractérisée en ce que**
la surface structurée (G) est formée de rugosités, de cannelures et/ou de surélévations ponctuelles et/ou linéaires et/ou de dépressions mises en place.

4. Clé USB selon la revendication 1, **caractérisée en ce que**
la surface structurée (G) dispose de propriétés adhésives.

5. Clé USB selon la revendication 1, **caractérisée en ce que**
des surélévations de la surface structurée (G) de la surface (B) abaissée pénètrent dans l'ouverture ménagée dans la surface (A) par l'abaissement.

6. Clé USB selon la revendication 2, **caractérisée en ce que**
la plaquette (F) est réalisée de façon ondulée.
